# EUROPEAN PATENT APPLICATION

(11) **EP 4 206 766 A1**
(43) Date of publication of application: **05.07.2023**
(21) Application number: 21861142.4
(22) Date of filing: 02.08.2021
(51) Int. Cl.: G02B 6/125, G02B 6/43, H01S 5/022

(54) **OPTICAL WAVEGUIDE PACKAGE, LIGHT-EMITTING DEVICE, AND PROJECTION SYSTEM**

(30) Priority: 26.08.2020 JP 2020142961
(71) Applicant: Kyocera Corporation, Kyoto-shi Kyoto 612-8501 (JP)
(72) Inventor: FUJIMOTO, Yasuhiro, Kyoto-shi, Kyoto 612-8501 (JP)
(74) Representative: Viering, Jentschura & Partner mbB Patent- und Rechtsanwälte
(86) International application number: PCT/JP2021/028639
(87) International publication number: WO 2022/044714

(57) **Abstract**

An optical waveguide package includes a substrate including a first surface, a cladding on the first surface, and a core in the cladding. A first distance from the first surface of the substrate to a first incident port of a first core differs from a second distance from the first surface to a second incident port of a second core.

## Description

### TECHNICAL FIELD

The present disclosure relates to an optical waveguide package, a light emitter, and a projection system.

### BACKGROUND OF INVENTION

A known technique is described in, for example, Patent Literature 1. A light generator described in Patent Literature 1 includes a semiconductor laser, an optical component, and an optical waveguide aligned relative to one another on a silicon substrate based on unevenness on the silicon substrate.

### CITATION LIST

### PATENT LITERATURE

Patent Literature 1: Japanese Unexamined Patent Application Publication No. 2012-114145

### SUMMARY

In an aspect of the present disclosure, an optical waveguide package includes a substrate including a first surface, a cladding located on the first surface, including a second surface facing the first surface and a third surface opposite to the second surface, and including an element mount portion with an opening in the third surface, a first core including a first incident port to receive first light from a first element mounted on the element mount portion and extending from the first incidence port in a direction away from the element mount portion, and a second core including a second incident port to receive second light from a second element mounted on the element mount portion and extending from the second incidence port in a direction away from the element mount portion. A distance D1 from the first surface to the first incident port differs from a distance D2 from the first surface to the second incident port.

In another aspect of the present disclosure, a light emitter includes the optical waveguide package described above, and a first element and a second element connected to the element mount portion. The distance D1 corresponds to a distance from the first surface to a light-emitting portion of the first element. The distance D2 corresponds to a distance from the first surface to a light-emitting portion of the second element.

In another aspect of the present disclosure, a projection system includes the light emitter described above, and a screen located on an optical path of light emitted from the light emitter.

### BRIEF DESCRIPTION OF THE DRAWINGS

The objects, features, and advantages of the present disclosure will become more apparent from the following detailed description and the drawings.
FIG. 1 is an exploded perspective view of a light emitter including an optical waveguide package according to an embodiment of the present disclosure.
FIG. 2 is a perspective view of the light emitter in FIG. 1 without illustrating a sealing lid.
FIG. 3 is a cross-sectional view of the light emitter taken along section line III-III in FIG. 2.
FIG. 4 is a cross-sectional view of the light-emitter taken along section line IV-IV in FIG. 2.
FIG. 5 is a plan view of the light emitter.
FIG. 6 is an enlarged view of the light emitter illustrating a portion near emission ports.
FIG. 7 is an exploded perspective view of a light emitter including an optical waveguide package according to another embodiment of the present disclosure.
FIG. 8 is a cross-sectional view of the light emitter taken along section line VIII-VIII in FIG. 7.
FIG. 9 is a schematic diagram of a projection system according to an embodiment of the present disclosure.

### DESCRIPTION OF EMBODIMENTS

Light-emitting elements that emit different colors (wavelengths) of light include light-emitting portions at different positions. Such light-emitting elements mounted on a substrate thus include the light-emitting portions at different distances from the surface of the substrate. Although the difference in distance may be as small as 1 µm or less, such a difference can greatly lower the efficiency of coupling with an optical waveguide. A known device described in Patent Literature 1 allows a semiconductor laser, an optical component, and an optical waveguide to be aligned relative to one another. However, the technique described in Patent Literature 1 does not focus on any positional difference between light-emitting portions of light-emitting elements (semiconductor lasers) and thus may not avoid lowering the efficiency of coupling with the optical waveguide. A light emitter with highly efficient coupling with an optical waveguide is thus awaited.

A light emitter according to one or more embodiments of the present disclosure will now be described with reference to the accompanying drawings. In the present embodiment, an optical waveguide package 100 includes a substrate 1 including a first surface 2, a cladding 3 located on the first surface 2 and including element mount portions 8 each having an opening in a third surface 3b opposite to a second surface 3a facing the first surface 2, and a core 4 located in the cladding 3. The optical waveguide package 100 further includes a sealing lid 11 and a lens 45.

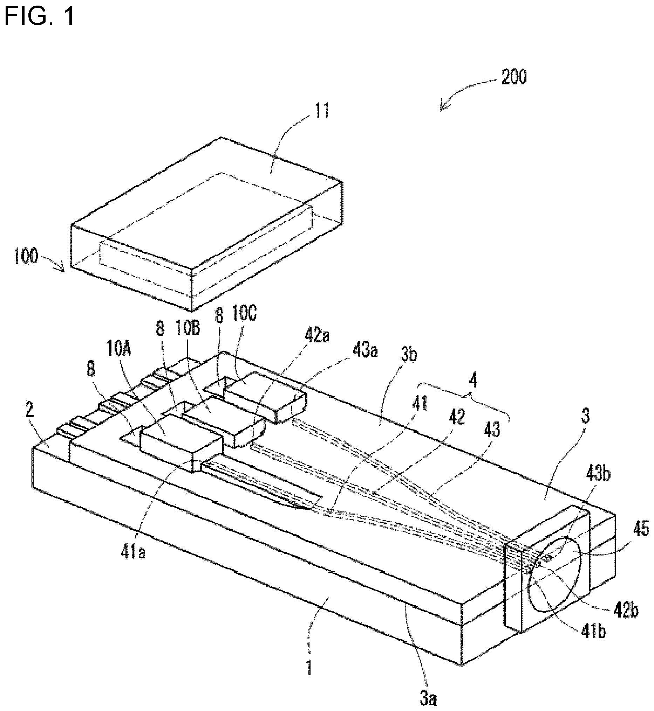

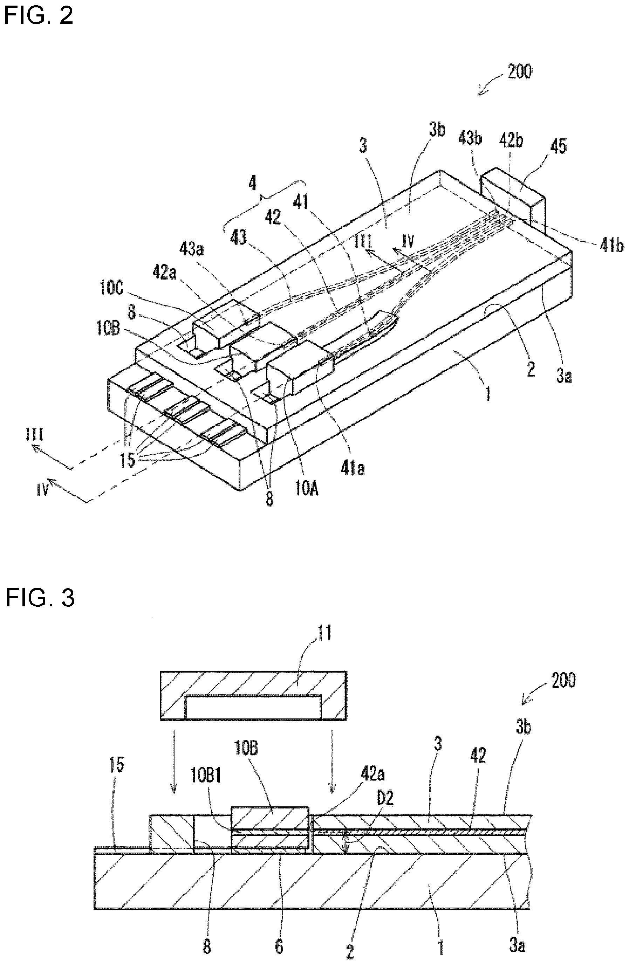

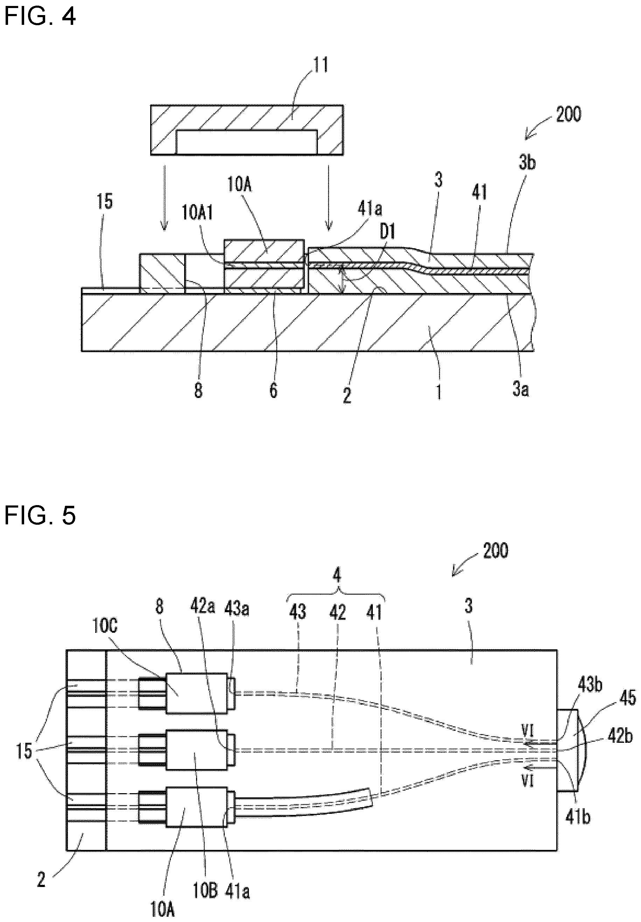

In the embodiment described in FIGs. 1 to 5, the optical waveguide package 100 includes element mount portions 8 on which a first element 10A and a second element 10B that are light-emitting elements are mountable. A light emitter 200 includes the optical waveguide package 100 and the first element 10A and the second element 10B. In the present embodiment, the optical waveguide package 100 further includes an element mount portion 8 on which a third element 10C that is a light-emitting element is mountable. The light emitter 200 includes the third element 10C. In the embodiment of the present disclosure, the light emitter 200 includes the third element 10C, but is not limited to this structure and may include, for example, the first element 10A and the second element 10B alone. The light-emitting elements may be laser diodes.

The substrate 1 includes element mounts 6 in areas defined by the element mount portions 8 on the first surface 2. The element mounts 6 join the elements 10A, 10B, and 10C to the first surface 2 of the substrate 1. The element mounts 6 may include, for example, metal members such as metalized layers on the first surface 2 of the substrate 1. The metal members in the element mounts 6 may be joined to the elements 10A, 10B, and 10C with a die bonding material such as a brazing material or an adhesive. In the present embodiment, the metal members in the element mounts 6 are connected to external wires 15. The elements 10A, 10B, and 10C include electrodes on their lower surfaces electrically connectable to the metal members in the element mounts 6 to be electrically connected to, for example, an external power circuit through the external wires 15. The external wires 15 may extend from inside the element mount portions 8 to outside the element mount portions 8. The elements 10A, 10B, and 10C include electrodes on their upper surfaces that may be electrically connected to the external wires 15 (without being connected to the metal members in the element mounts 6) with, for example, bonding wires (not illustrated).

In the present embodiment, light emitted from the first element 10A (first light) and light emitted from the second element 10B (second light) have different colors. In the present embodiment, light emitted from the first element 10A, light emitted from the second element 10B, and light emitted from the third element 10C (third light) have different colors. For example, light emitted from the first element 10A is red light, and light emitted from the second element 10B is green light. Light emitted from the third element 10C is, for example, blue light. The first element 10A is, for example, a laser diode including a gallium arsenide (GaAs) semiconductor. The second element 10B and the third element 10C are, for example, laser diodes each including a gallium nitride (GaN) semiconductor. Being made of different semiconductors, the first element 10A, the second element 10B, and the third element 10C include light-emitting portions at different positions.

The first surface 2 of the substrate 1 is flat at least in the element mount portions 8. The first element 10A, the second element 10B, and the third element 10C mounted on the flat surface have different distances from the first surface 2 to their respective light-emitting portions. In the present embodiment, the distance from the first surface 2 to a light-emitting portion 10A1 of the first element 10A including a gallium arsenide semiconductor is greater than the distance from the first surface 2 to a light-emitting portion 10B1 of the second element 10B including a gallium nitride semiconductor. The third element 10C, including a gallium nitride semiconductor similarly to the second element 10B, has the same distance from the first surface 2 to its light-emitting portion as the second element 10B.

The substrate 1 may be a ceramic wiring board containing a ceramic material. Examples of the ceramic material used for the ceramic wiring board include sintered aluminum oxide, sintered mullite, sintered silicon carbide, sintered aluminum nitride, and sintered glass ceramic. The ceramic wiring board may include conductors such as connection pads, internal wiring conductors, and external connection terminals for electrical connection between light-emitting and light-receiving elements and an external circuit. The ceramic wiring board may be a stack of layers.

The substrate 1 may be an organic wiring board containing an organic material. The organic wiring board may be a printed wiring board, a build-up wiring board, or a flexible wiring board. Examples of the organic material used for the organic wiring board include an epoxy resin, a polyimide resin, a polyester resin, an acrylic resin, a phenolic resin, and a fluororesin. The organic wiring board may be a stack of layers.

The substrate 1 may be made of a compound semiconductor such as GaN, GaAs, or indium phosphide (InP), or made of silicon (Si), germanium (Ge), or sapphire (Al₂O₃).

The cladding 3 and the core 4 may be made of, for example, glass such as quartz, or a resin. Both the cladding 3 and the core 4 may be made of glass or a resin. In some embodiments, one of the cladding 3 or the core 4 may be made of glass, and the other may be made of a resin. The core 4 and the cladding 3 have different refractive indexes, or more specifically, the core 4 has a higher refractive index than the cladding 3. Light traveling through the core 4 is fully reflected at the interfaces with the cladding 3 due to this difference in the refractive index. More specifically, a material with a higher refractive index is used to form a path, which is then surrounded by a material with a lower refractive index. This structure confines light in the core 4 with the higher refractive index and allows the light to travel.

The core 4 includes a first core 41 corresponding to the first element 10A and a second core 42 corresponding the second element 10B. The core 4 further includes a third core 43 corresponding to the third element 10C. The first core 41 includes a first incident port 41a receiving the first light from the first element 10A mounted on the corresponding element mount portion 8 and extends from the first incident port 41a in the direction away from the element mount portion 8. The second core 42 includes a second incident port 42a receiving the second light from the second element 10B mounted on the corresponding element mount portion 8 and extends from the second incident port 42a in the direction away from the element mount portion 8. The third core 43 includes a third incident port 43a receiving the third light from the third element 10C mounted on the corresponding element mount portion 8 and extends from the third incident port 43a in the direction away from the element mount portion 8.

In the present embodiment, the first core 41, the second core 42, and the third core 43 are separate from one another in the cladding 3. The first core 41 includes a first emission port 41b at an end opposite to the first incident port 41a. The second core 42 includes a second emission port 42b at an end opposite to the second incident port 42a. The third core 43 includes a third emission port 43b at an end opposite to the third incident port 43a.

Red light emitted from the first element 10A enters the first core 41 through the first incident port 41a, travels through the first core 41, and is emitted through the first emission port 41b. Green light emitted from the second element 10B enters the second core 42 through the second incident port 42a, travels through the second core 42, and is emitted through the second emission port 42b. Blue light emitted from the third element 10C enters the third core 43 through the third incident port 43a, travels through the third core 43, and is emitted through the third emission port 43b. In the present embodiment, both the first emission port 41b of the first core 41 and the second emission port 42b of the second core 42 are exposed at the end face of the cladding 3. The third emission port 43b of the third core 43 is also exposed at the end face of the cladding 3.

In the optical waveguide package 100 according to the present embodiment, a distance D1 from the first surface 2 of the substrate 1 to the first incident port 41a of the first core 41 differs from a distance D2 from the first surface 2 to the second incident port 42a of the second core 42. The distance D1 is from the first surface 2 to the middle of the first incident port 41a. The distance D2 is from the first surface 2 to the middle of the second incident port 42a. As described above, the first element 10A includes its light-emitting portion at a position different from the positions of the light-emitting portions of the second element 10B and the third element 10C. The first element 10A mounted on the first surface 2 of the substrate 1 thus has a distance from the first surface 2 to the light-emitting portion different from the distances from the second surface 2 to the light-emitting portions of the second element 10B and the third element 10C. These distances correspond to the distance D1 and the distance D2. In the present embodiment, for example, the distance from the first surface 2 to the light-emitting portion 10A1 of the first element 10A is greater than the distance from the first surface 2 to the light-emitting portion 10B1 of the second element 10B. In this case, the distance D1 is set greater than the distance D2. The optical waveguide package 100 with this structure has less height position differences between the light-emitting elements and the emission ports of the cores, thus achieving highly efficient coupling with the core. Such highly accurate positioning is more likely to be achieved by adjusting the height position of the core 4 by, for example, adjusting the thickness of the deposition film of the cladding 3 in manufacturing the cladding 3 and the core 4 than by adjusting the height positions of the light-emitting elements in manufacturing the substrate 1 or postprocessing the first surface 2 as with known techniques. The third element 10C, which is the same or similar to the second element 10B, may have the distance from the first surface 2 to the third incident port 43a of the third core 43 that is the same as the distance D2 from the first surface 2 to the second incident port 42a of the second core 42.

The lens 45 is located on the optical path of light emitted through each of the first emission port 41b and the second emission port 42b, and on the optical path of light emitted through the third emission port 43b. The lens 45 may be, for example, a condenser lens with a flat incident surface and a convex emission surface.

For example, the light emitter 200 can be used as a light source for a projection system, as described later. Light emitted from the light emitter 200 (light passing through the lens 45) is reflected from a scanning mirror and reaches a screen. For example, the reflection angle of the scanning mirror is changed to cause light emitted from the light emitter 200 to be projected at a different position on the screen. A color image can be displayed on the screen by continuously changing the position at which light is projected on the screen.

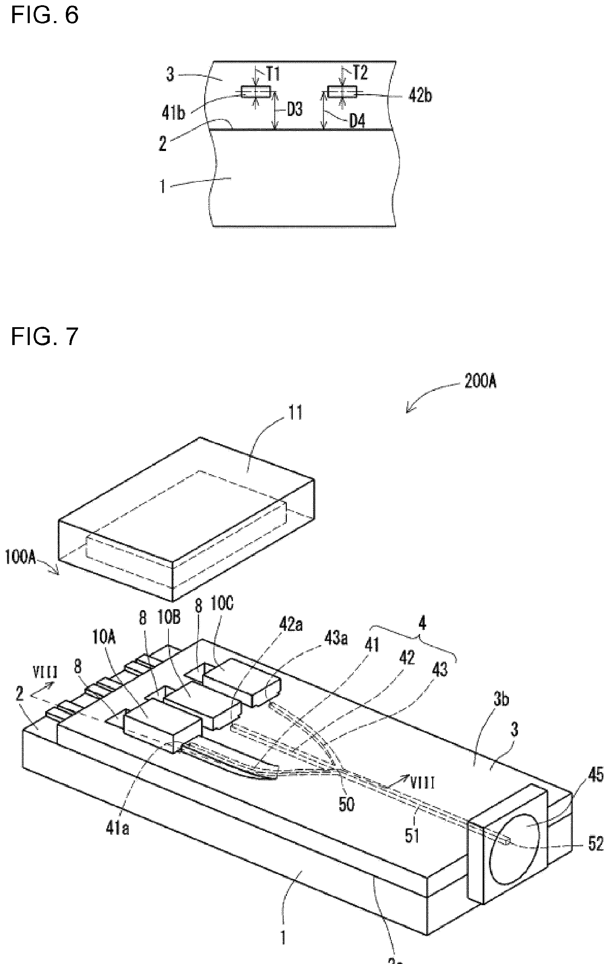

FIG. 6 is an enlarged view of the light emitter 200 illustrating a portion near the emission ports. In the present embodiment, a thickness T1 of the first core 41 is the same as a thickness T2 of the second core 42, and the difference between a distance D3 from the first surface 2 of the substrate 1 to the first emission port 41b of the first core 41 and a distance D4 from the first surface 2 of the substrate 1 to the second emission port 42b is less than or equal to half the thickness T1 of the first core 41. The thickness T1 of the first core 41 and the thickness T2 of the second core 42 being the same herein refers to the thickness T1 and the thickness T2 being set the same but their actual thicknesses being within ±20% of the set thicknesses to accommodate manufacturing variations in the core 4 formed by film deposition. The distance D3 is from the first surface 2 to the middle of the first emission port 41b. The distance D4 is from the first surface 2 to the middle of the second emission port 42b. The thickness of the third core 43 is also the same as the thickness of the first core 41, and the difference between the distance D3 from the first surface 2 of the substrate 1 to the first emission port 41b of the first core 41 and the distance from the first surface 2 of the substrate 1 to the third emission port 43b may be less than or equal to half the thickness T1 of the first core 41. Red light from the first core 41 and green light from the second core 42 are emitted from the same position, and blue light from the third core 43 is also emitted from the same position as the red light and the green light. In a projection system including the light emitter 200 described above, the three colors of light beams emitted from the same position facilitate control of the timing to emit light from each light-emitting element and the timing to change the reflection angle of the scanning mirror.

The sealing lid 11 covering the element mount portions 8 is on the third surface 3b of the cladding 3. The sealing lid 11 airtightly seals the space accommodating the elements 10A, 10B, and 10C (the space defined by the first surface 2 of the substrate 1, the element mount portions 8, and the sealing lid 11). The sealing lid 11 may be made of a glass material such as quartz, borosilicate, or sapphire. The sealing lid 11 may be made of a metal such as Fe, Ni, or Co, an alloy containing one or more of these metals, or silicon.

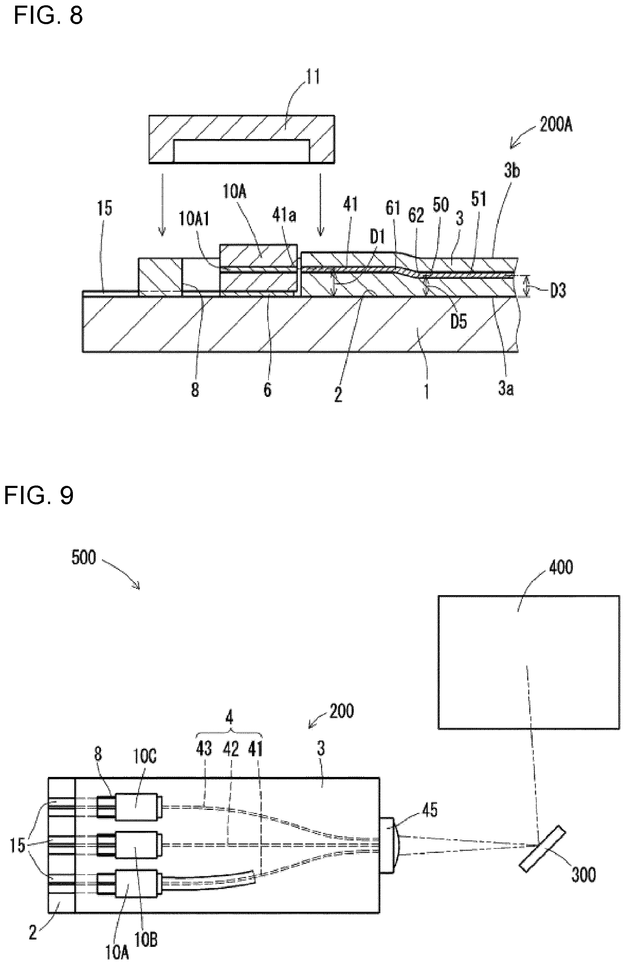

FIG. 7 is an exploded perspective view of a light emitter 200A including an optical waveguide package 100 A according to another embodiment of the present disclosure. FIG. 8 is a cross-sectional view of the light emitter 200A taken along section line VIII-VIII in FIG. 7. The same reference numerals denote the components corresponding to those in the above embodiment, and such components will not be described repeatedly. The present embodiment differs from the above embodiment in that the first core 41 and the second core 42 merge at a merging point 50 in the cladding 3. In the present embodiment, the third core 43 also merges at the merging point 50. The cores merge together into a single joining path 51 at the merging point 50 to emit light through an emission port 52. More specifically, red light traveling through the first core 41, green light traveling through the second core 42, and blue light traveling through the third core 43 merge at the merging point 50 to travel through the joining path 51 before being emitted through the emission port 52 as a single beam of merged light. A projection system including the light emitter 200 described above can use the merged light as a single beam of light that is easily controllable.

In the structure including the merging point 50 as in the present embodiment, merging of the first core 41 and the second core 42 refers to merging of the first core 41 with the second core 42. As described above, the first incident port 41a of the first core 41 is located more distant from the first surface 2 than the second incident port 42a of the second core 42. In the second core 42, the distance from the first surface 2 is constant between the second incident port 42a and the merging point 50. In the first core 41, the distance D1 from the first surface 2 decreases to the distance D2 between the first incident port 41a and the merging point 50. In the first core 41, the distance D1 from the first surface 2 may change to the distance D2 continuously or intermittently between the first incident port 41a and the merging point 50. In the present embodiment, the first core 41 includes a first bend 61 and a second bend 62 between the first incident port 41a and the merging point 50. The first bend 61 is located closer to the first incident port 41a than the second bend 62. The distance from the first surface 2 of the substrate 1 starts changing at the first bend 61. The distance from the first surface 2 of the substrate 1 stops changing at the second bend 62. The first core 41 has a constant distance from the first surface 2 and extends parallel to the first surface 2 between the first incident port 41a and the first bend 61. The distance from the first surface 2 continuously decreases between the first bend 61 and the second bend 62. The first core 41 has a distance D5 from the first surface 2 between the second bend 62 and the merging point 50. The distance D5 is equal to the distance D2 ± half the thickness T1 of the first core 41. The first core 41 has the constant distance D5 from the first surface 2 and extends parallel to the first surface 2 between the second bend 62 and the merging point 50, and merges with the second core 42 at the merging point 50. The optical waveguide package 100A with this structure has less scattering of light resulting from red light traveling through the first core 41 merging with green light traveling through the second core 42 at the merging point 50, thus causing less loss of emitted light.

In the optical waveguide packages 100 and 100A and the light emitters 200 and 200A described with reference to FIGs. 1 to 8, the cladding 3 includes the element mount portions 8 as through-holes, but is not limited to this structure. The element mount portions 8 may be recesses being open on the third surface 3b, rather than the through-holes. The cladding 3 may be a plate including the incident port and the emission port of the core 4.

FIG. 9 is a schematic diagram of a projection system 500 according to an embodiment of the present disclosure. The projection system 500 includes the light emitter 200 and a screen 400. The screen 400 is located on the optical path of light emitted from the light emitter 200. The projection system 500 may include the light emitter 200A instead of the light emitter 200. In the present embodiment, the projection system 500 further includes a scanning mirror 300. Light emitted from the light emitter 200 is reflected from the scanning mirror 300 and has its optical path redirected to be projected on the screen 400. For example, the reflection angle of the scanning mirror 300 is changed to cause light emitted from the light emitter 200 to be projected at a different position on the screen 400. A color image can be displayed on the screen 400 by continuously changing the position at which light is projected on the screen 400.

The scanning mirror 300 may be any device that can change the reflection angle precisely and continuously in a short time. For example, a micromirror using micro electromechanical systems (MEMS) may be used. The scanning mirror 300 may be, for example, a polygon scanner, a galvanometer scanner, or a resonant scanner, other than a micromirror. The screen 400 may be a diffuse screen, a retrograde screen, a reflective screen, or a rear screen. The screen 400 may also be the retina of an observer.

In still another embodiment of the present disclosure, the elements 10A, 10B, and 10C are not limited to laser diodes (LDs) but may be, for example, light-emitting diodes (LEDs) or vertical-cavity surface-emitting lasers (VCSELs).

The present disclosure may be implemented in the following forms.

In an embodiment of the present disclosure, an optical waveguide package includes a substrate including a first surface, a cladding located on the first surface, including a second surface facing the first surface and a third surface opposite to the second surface, and including an element mount portion with an opening in the third surface, a first core including a first incident port to receive first light from a first element mounted on the element mount portion and extending from the first incidence port in a direction away from the element mount portion, and a second core including a second incident port to receive second light from a second element mounted on the element mount portion and extending from the second incidence port in a direction away from the element mount portion. A distance D1 from the first surface to the first incident port differs from a distance D2 from the first surface to the second incident port.

In another embodiment of the present disclosure, a light emitter includes the optical waveguide package described above, and a first element and a second element connected to the element mount portion. The distance D1 corresponds to a distance from the first surface to a light-emitting portion of the first element. The distance D2 corresponds to a distance from the first surface to a light-emitting portion of the second element.

In another embodiment of the present disclosure, a projection system includes the light emitter described above, and a screen located on an optical path of light emitted from the light emitter.

In one or more embodiments of the present disclosure, the optical waveguide package and the light emitter can have highly efficient coupling with an optical waveguide.

Although embodiments of the present disclosure have been described in detail, the present disclosure is not limited to the embodiments described above, and may be changed or varied in various manners without departing from the spirit and scope of the present disclosure. The components described in the above embodiments may be entirely or partially combined as appropriate unless any contradiction arises.

### REFERENCE SIGNS

- 1: substrate
- 2: first surface
- 3: cladding
- 3a: second surface
- 3b: third surface
- 4: core
- 6: element mount
- 8: element mount portion
- 10A: first element
- 10A1: light-emitting portion
- 10B: second element
- 10B1: light-emitting portion
- 10C: third element
- 11: sealing lid
- 15: external wire
- 41: first core
- 41a: first incident port
- 41b: first emission port
- 42: second core
- 42a: second incident port
- 42b: second emission port
- 43: third core
- 43a: third incident port
- 43b: third emission port
- 45: lens
- 50: merging point
- 51: joining path
- 52: emission end face
- 100, 100A: optical waveguide package
- 200, 200A: light emitter
- 300: scanning mirror
- 400: screen
- 500: projection system

## Claims

1. An optical waveguide package, comprising:
a substrate including a first surface;
a cladding on the first surface, the cladding including a second surface facing the first surface and a third surface opposite to the second surface, the cladding including an element mount portion with an opening in the third surface;
a first core including a first incident port to receive first light from a first element mounted on the element mount portion, the first core extending from the first incidence port in a direction away from the element mount portion; and
a second core including a second incident port to receive second light from a second element mounted on the element mount portion, the second core extending from the second incidence port in a direction away from the element mount portion,
wherein a distance (D1) from the first surface to the first incident port differs from a distance (D2) from the first surface to the second incident port.

2. The optical waveguide package according to claim 1, wherein
the first core includes a first emission port for the first light,
the second core includes a second emission port for the second light,
the first core has a same thickness as the second core, and
a difference between a distance (D3) from the first surface to the first emission port and a distance (D4) from the first surface to the second emission port is less than or equal to half the thickness of the first core.

3. The optical waveguide package according to claim 1, wherein
the first core and the second core merge with each other at a merging point in the cladding.

4. The optical waveguide package according to claim 3, wherein
the first core includes a first bend and a second bend between the first incident port and the merging point,
the first bend is closer to the first incident port than the second bend and is a point at which the distance from the first surface starts changing, and
the second bend is a point at which the distance from the first surface stops changing, and a distance (D5) from the first surface between the second bend and the merging point is equal to the distance (D2) ± half the thickness of the first core.

5. A light emitter, comprising:
the optical waveguide package according to any one of claims 1 to 4; and
a first element and a second element connected to the element mount portion,
wherein the distance (D1) corresponds to a distance from the first surface to a light-emitting portion of the first element, and
the distance (D2) corresponds to a distance from the first surface to a light-emitting portion of the second element.

6. A projection system, comprising:
the light emitter according to claim 5; and
a screen located on an optical path of light emitted from the light emitter.
